# EUROPEAN PATENT APPLICATION

(11) **EP 2 224 490 A1**
(43) Date of publication of application: **01.09.2010**
(21) Application number: 08855870.5
(22) Date of filing: 05.12.2008
(51) Int. Cl.: H01L 29/786, G02F 1/1368, H01L 51/50

(54) **CONTROL SUBSTRATE AND CONTROL SUBSTRATE MANUFACTURING METHOD**

(30) Priority: 07.12.2007 JP 2007316771
(71) Applicant: Sumitomo Chemical Company, Limited, Tokyo 104-8260 (JP)
(72) Inventor: NISHIOKA, Yukiya, Nara-shi Nara 631-0034 (JP); MATSUMURO, Tomonori, Tsukuba-shi Ibaraki 305-0051 (JP); KASAHARA, Kenji, Tsukuba-shi Ibaraki 300-3261 (JP)
(74) Representative: Jackson, Martin Peter
(86) International application number: PCT/JP2008/072593
(87) International publication number: WO 2009/072675

(57) **Abstract**

A control substrate comprising:
a substrate main body;
a base layer provided on one surface perpendicular to a thickness direction of the substrate main body; and
a switching element provided on the base layer's surface located on the opposite side to the substrate main body ,so as to perform switching between an electric connection and an electric disconnection,
wherein the switching element comprises an electrode formed on the surface of the base layer by an application method,the surface being opposite to the substrate main body , and
the base layer is formed of a member whose adhesiveness to the electrode is higher than the adhesiveness of the substrate main body to an electrode when forming the electrode on a base layer side surface of the substrate main body by an application method.

## Description

### TECHNICAL FIELD

The present invention relates to a control substrate for switching between an electric connection and an electric disconnection, and a method for manufacturing the control substrate.

### BACKGROUND ART

Display devices such as liquid crystal display devices and organic EL display devices include a plurality of light emitting elements, and each light emitting element is selectively permitted to emit light, thereby displaying predetermined image information. Driving methods for permitting the light emitting elements to emit light include passive driving and active driving. In an active driving display device, for example, field effective transistors (FETs) are disposed between each light emitting element and a power supply, and selective switching between a conduction state and a non-conduction state of each FET selectively permits each light emitting element to emit light, thereby displaying predetermined image information. In an active driving display device, a control substrate is used such as a TFT (Thin Film Transistor) substrate with a plurality of FETs provided on a substrate main body.

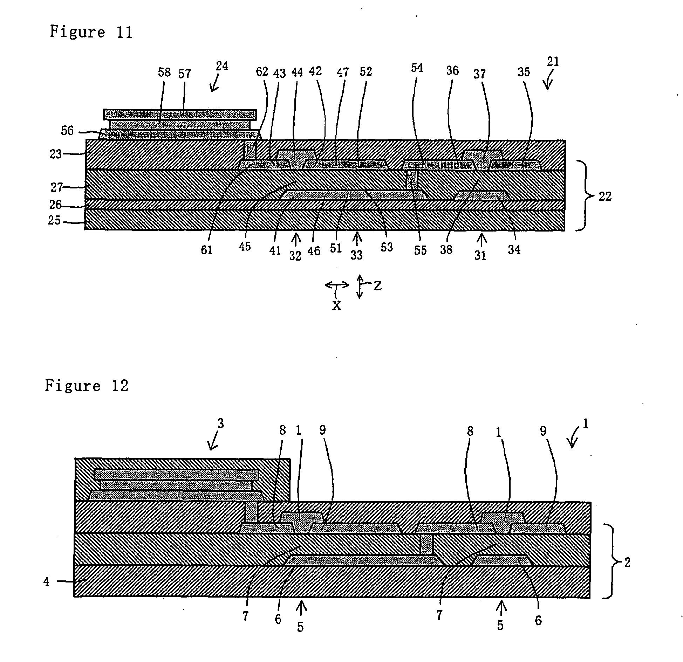

FIG. 12 is a cross-sectional view schematically illustrating a display device 1 of the prior art. The display device 1 includes a TFT substrate 2, and a light emitting element 3 provided on the TFT substrate 2. The TFT substrate 2 includes a substrate main body 4, and an FET (Field Effective Transistor) 5 provided on the substrate main body 4. The FET 5 includes a gate electrode 6 formed on one surface perpendicular to a thickness direction of the substrate main body 4, a gate insulating film 7 formed over the gate electrode 6, a source electrode 8 and a drain electrode 9 formed on one surface perpendicular to the thickness direction of the insulating film 7, and a semiconductor layer 10 formed between the source electrode 8 and the drain electrode 9.

In accordance with conventional techniques, the use of sputtering, evaporation, and CVD, etc. forms the FET 5 on the substrate main body 4 to manufacture the TFT substrate 2, and further forms the light emitting element 3 on the TFT substrate 2, thereby manufacturing the display device 1.

In sputtering, evaporation, and CVD, etc., it is necessary to form the FET in vacuum by use of a vacuum apparatus, thereby leading to high manufacturing cost. Thus, as a method for forming the FET 5 at low cost without the use of any vacuum apparatus, for example, the formation of the FET 5 by an application method is conceivable. In conventional techniques, an ink for the formation of wirings is applied which contains a metal paste and metal nanoparticles, etc., and further baked, thereby forming conductive wirings on a substrate (for example, see Japanese Patent Application Laid-Open No. 2007-169604).

### DISCLOSURE OF THE INVENTION

In the case of forming the elements such as the FET by, for example, an application method, it has been difficult to form a high reliability element, as compared with a case of forming a film by sputtering.

An object of the present invention is to provide a control substrate including a high reliability switching element formed on a substrate main body, and a method for manufacturing the control substrate by an application method.

In addition, when accumulation is caused or failed patterning is caused in the step subsequent to the formation of the gate electrode 6 and the wirings on the substrate main body 4, a cleaning process and a predetermined process are carried out again as so-called reprocessing. There is fear that the less adhesive gate electrode 6, wirings, etc. formed by the application method will be peeled in such reprocessing, resulting in decrease in yield and difficulty in forming highly reliable elements such as the FET 5.

The inventors have earnestly considered elements formed by application methods, and as a result, conceived of the fact that the adhesive feature for electrodes of elements is associated with the reliability for the elements, and found that even in the case of forming an element by an application method, a highly reliable element can be obtained by providing a base layer on a surface of a substrate main body and providing an electrode for an element on the base layer, thereby completing the present invention.

The present invention provides a control substrate comprising:
a substrate main body;
a base layer provided on one surface perpendicular to a thickness direction of the substrate main body; and
a switching element provided on the base layer's surface located on the opposite side to the substrate main body ,so as to perform switching between an electric connection and an electric disconnection,
   wherein the switching element comprises an electrode formed on the surface perpendicular to the thickness direction of the base layer by the application method, and
the base layer is formed of a member whose adhesiveness to the electrode is higher than the adhesiveness of the substrate main body to an electrode when forming the electrode on a base layer side surface of the substrate main body by an application method.

### BRIEF EXPLANATION OF DRAWINGS

FIG. 1 is a cross-sectional view schematically illustrating a display device 21 according to an embodiment of the present invention.
FIG. 2 is a plan view schematically illustrating the display device 21.
FIG. 3 is an equivalent circuit diagram of the display device 21.
FIG. 4 is a cross-sectional view schematically illustrating a manufacturing step for the display device 21.
FIG. 5 is a cross-sectional view schematically illustrating a manufacturing step for the display device 21.
FIG. 6 is a cross-sectional view schematically illustrating a manufacturing step for the display device 21.
FIG. 7 is a cross-sectional view schematically illustrating a manufacturing step for the display device 21.
FIG. 8 is a cross-sectional view schematically illustrating a manufacturing step for the display device 21.
FIG. 9 is a cross-sectional view schematically illustrating a manufacturing step for the display device 21.
FIG. 10 is a cross-sectional view schematically illustrating a manufacturing step for the display device 21.
FIG. 11 is a cross-sectional view schematically illustrating a manufacturing step for the display device 21.
FIG. 12 is a cross-sectional view schematically illustrating a display device 1 of prior art.

### DESCRIPTION OF REFERENCE SYMBOLS

- 21: display device
- 22: TFT substrate
- 23: interlayer insulating layer
- 24: light emitting element
- 25: substrate main body
- 26: base layer
- 27: intermediate layer
- 31: switching transistor
- 32: driving transistor
- 33: capacitor
- 34: first gate electrode
- 35: first drain electrode
- 36: first source electrode
- 37: first semiconductor layer
- 38: first gate insulating film
- 41: second gate electrode
- 42: second drain electrode
- 43: second source electrode
- 44: second semiconductor-layer
- 45: second gate insulating film
- 53: dielectric section
- 56: first electrode
- 57: second electrode
- 58: organic layer
- 59: protective film

### MODE FOR CARRYING OUT THE INVENTION

A TFT substrate 22 corresponding to a control substrate according to the present embodiment includes a substrate main body 25, a base layer 26 provided on one surface perpendicular to a thickness direction Z of the substrate main body 25, and switching elements (a switching transistor 31 and a driving transistor 32 described below) provided on the surface of the base layer 26 opposite to the substrate main body for switching between an electric connection and an electric disconnection, and the TFT substrate 22 is **characterized in that** the switching elements respectively have electrode (a first gate electrode 34 and a second gate electrode 41 described below) formed by an application method on one surface perpendicular to the thickness direction of the base layer 26, and the base layer 26 is formed of a member whose adhesiveness to electrodes is higher than the adhesiveness of a substrate main body 25 to electrodes when forming the electrodes on one surface of the substrate main body 25 by an application method. It is often the case that the surface of the substrate main body 25 has high flatness like a mirror surface, and when a conductive film is formed on the surface of the substrate main body 25 by an application method, the adhesion effect (anchoring) is not always sufficient, and there is a tendency among electrodes and wirings formed on the substrate main body 25 to peel easily. However, the base layer 26 provided as described above improves the adhesiveness of the electrodes, as compared with cases of forming the electrodes directly on the substrate main body 25 without providing the base layer 26, thereby allowing a control substrate provided with highly reliable switching elements with their electrodes having a high adhesiveness to be obtained.

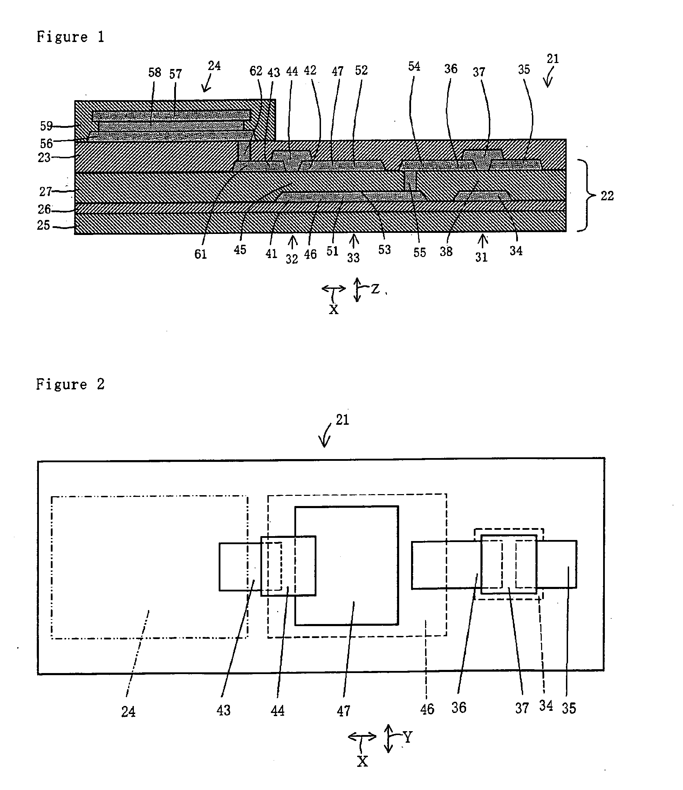

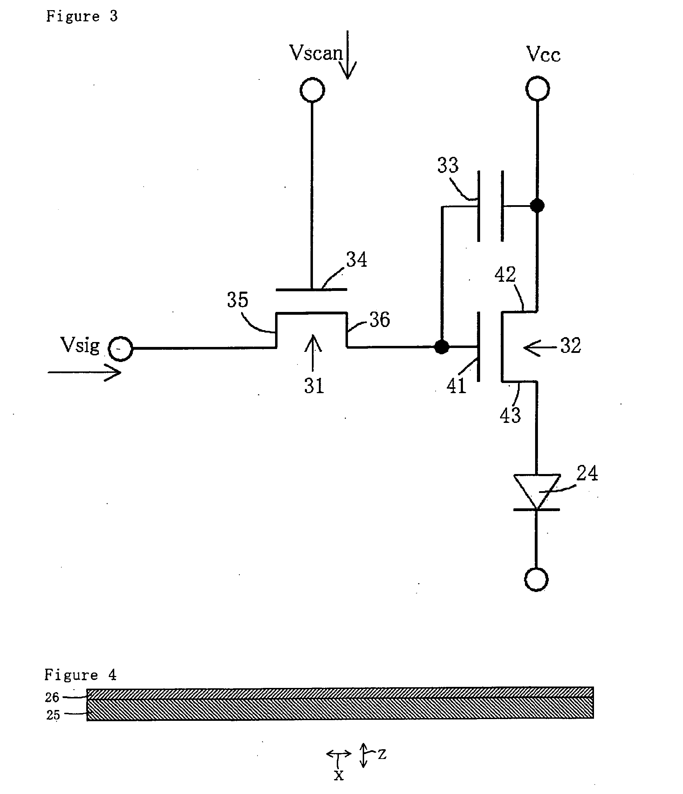

FIG. 1 is a cross-sectional view schematically illustrating a display device 21 according to an embodiment of the present invention, FIG. 2 is a plan view schematically illustrating a TFT substrate22 according to an embodiment of the present invention, which is provided in the display device 21, and FIG. 3 is an equivalent circuit diagram of the display device 21. While the display device 21 according to the present invention is configured to include a plurality of pixels, FIGS. 1 through 3 show only elements constituting one pixel among the plurality of pixels, for the sake of convenience. Unless otherwise noted, the elements constituting one pixel will be described below.

The display device 21 is configured to include the TFT substrate 22 corresponding to the control substrate, an interlayer insulating layer 23 provided on one surface perpendicular to a thickness direction of the TFT substrate 22 (hereinafter, referred to as a thickness direction Z), and a light-emitting element 24 provided on one surface perpendicular to the thickness direction Z of the interlayer insulating layer 23.

The TFT substrate 22 is mainly composed of the substrate main body 25, the base layer 26, and the intermediate layer 27, which are staked in this order perpendicular to the thickness direction Z, and further includes one or more elements. The TFT substrate 22 according to the present embodiment include, as the elements, the switching transistor 31 and driving transistor 32 provided on the bases layer and corresponding to switching elements for switching between an electric connection and an electric disconnection, and a capacitor 33.

The switching transistor 31 and driving transistor 32 are each achieved by a field effect transistor (FET).

The switching transistor 31 according to the present embodiment is achieved by a so-called bottom gate FET, which includes the first gate electrode 34, a first drain electrode 35, a first source electrode 36, a first semiconductor layer 37, and a first gate insulating film 38.

The first gate electrode 34 is conductive, and formed on one surface perpendicular to the thickness direction Z of the base layer 26. The first gate electrode 34 is formed in the shape of a substantially rectangular parallelepiped plate in the present embodiment. Furthermore, for example, a wiring connected to the first gate electrode 34 is formed on the surface perpendicular to the thickness direction Z of the base layer 26.

The first drain electrode 35 and the first source electrode 36 are conductive, each placed spaced apart from each other in a first direction X on one surface perpendicular to the thickness direction Z of the intermediate layer 27, and each formed in the shape of a substantially rectangular parallelepiped plate. A gap between the first drain electrode 35 and the first source electrode 36 is located to overlap with the first gate electrode 34 as viewed from one side perpendicular to the thickness direction Z, and in the present embodiment, provided in a central section of the first gate electrode 34 in the first direction X. The gap between the first drain electrode 35 and the first source electrode 36 corresponds to a channel length, which is determined depending on electrical characteristics of a desired FET, and for example, to be 5 µm to 6 µm. In addition, a width for the first drain electrode 35 and the first source electrode 36 in the second direction Y perpendicular to each of the first direction X and the thickness direction Z corresponds to a channel width, which is determined depending on electrical characteristics of a desired FET. The channel width is determined to be 1.00 µm to 300 µm in the case of forming the first semiconductor layer 37 by the use of an organic material.

The gap between the first drain electrode 35 and the first source electrode 36 is filled with the first semiconductor layer 37, which is further formed to cover ends of the first drain electrode 35 and first source electrode facing the gap. The first semiconductor layer 37 is formed of an n-type or p-type organic or inorganic semiconductor.

The first gate insulating film 38 is a section of the intermediate layer 27, which is formed to cover at least the first gate electrode 34. The first gate insulating film 38 is achieved by permitting a section of the intermediate layer 27 sandwiched between the first drain electrode 35, first source electrode 36, and first semiconductor layer 37 and the first gate electrode 34 to serve as a gate insulating film for a FET.

The driving transistor 32 is achieved by a so-called bottom gate FET, which is configured to include the second gate electrode 41, a second drain electrode 42, a second source electrode 43, a second semiconductor layer 44, and a second gate insulating film 45. The driving transistor 32 is spaced at a predetermined interval in the first direction X with respect to the switching transistor 31.

The second gate electrode 41 is spaced at an interval in the first direction X with respect to the first gate electrode 34 on one surface perpendicular to the thickness direction of the base layer 26. In the present embodiment, a section of a lower conductor plate 46 spaced at an interval in the first direction X with respect to the first gate electrode 34 on one surface perpendicular to the thickness direction Z of the base layer 26 functions as the second gate electrode 41. Specifically, an end of the lower conductor plate 46 in the first direction X and a central section in a second direction Y function as the second gate electrode 41.

The second drain electrode 42 and the second source electrode 43 are conductive, each placed spaced apart from each other in a first direction X on one surface perpendicular to the thickness direction Z of the intermediate layer 27, and each formed in the shape of a substantially rectangular parallelepiped plate. The second drain electrode 42 is disposed with respect to the other side in the first direction X with respect to the second electrode 43. A gap between the second drain electrode 42 and the second source electrode 43 is located to overlap with the second gate electrode 41 as viewed from one side perpendicular to the thickness direction Z, and in the present embodiment, provided in a central section of the second gate electrode 41 in the first direction X. In the present embodiment, a section of an upper conductor plate 47 spaced at an interval in the first direction X with respect to the first source electrode 36 of the switching transistor 31 on one surface perpendicular to the thickness direction Z of the intermediate layer 27 functions as the second drain electrode 42. Specifically, an end of the upper conductor plate 47 in the first direction X and a central section in the second direction Y function as the second drain electrode 42.

The gap between the second drain electrode 42 and the second source electrode 43 corresponds to a channel length, whereas a width in the second direction Y for the second drain electrode 42 and second source electrode 43 opposed to each other in the first direction X corresponds to a channel width. The channel length and channel width are each determined depending on electrical characteristics of a desired FET, and for example, each determined in the same way as the channel length and channel width of the switching transistor 31 described above.

The gap between the second drain electrode 42 and the second source electrode 43 is filled with the second semiconductor layer 44, which is further formed to cover ends of the second drain electrode 42 and second source electrode 43 facing the gap. The first semiconductor layer 37 is formed of an n-type or p-type organic or inorganic semiconductor.

The second gate insulating film 45 is a section of the intermediate layer 27, which is formed to cover at least the second gate electrode 41. The second gate insulating film 45 is achieved by permitting a section of the intermediate layer 27 sandwiched between the second drain electrode 42, second source electrode 43, and second semiconductor layer 44 and the second gate electrode 41 to serve as a gate insulating film for a FET.

The first and second gate electrodes 34, 41 according to the present embodiment correspond to an electrode formed by an application method on one surface perpendicular to the thickness direction Z of the intermediate layer 26, and the first and second drain electrodes 35, 42 and the first and second source electrodes 36, 43 each correspond to an upper electrode formed by an application method on one surface perpendicular to the thickness direction Z of the base layer 26.

The capacitor 33 is configured to include one conductor plate 51, the other conductor plate 52, and a dielectric section 53, and provided between the switching transistor 31 and the driving transistor 32. The conductor plate 51 is provided on one surface perpendicular to the thickness direction Z of the base layer 26, and composed of a section of the lower conductor plate 46 described above. Specifically, the other region of the lower conductor plate 46 in the first direction X with respect to the section which functions as the second gate electrode 41 functions as the conductor plate 51. The other conductor plate 52 is provided on one surface perependicular to the thickness direction Z of the intermediate layer 27, and composed of a section of the lower conductor plate 47 described above. Specifically, the other region of the upper conductor plate 47 in the first direction X with respect to the section which functions as the second drain electrode 42 functions as the other conductor plate 51. The lower conductor plate 47 and the lower conductor plate 46 are at least partially opposed to each other perpendicular to the thickness direction Z, and the section of the lower conductor plate 46 opposed to the upper conductor plate 47 functions as the conductor plate 51, whereas the section of the upper conductor plate 47 opposed to the lower conductor plate 46 functions as the other conductor plate 52.

The dielectric section 53 is composed of a section of the intermediate layer 27, or composed of a section of the intermediate layer 27 between the lower conductor plate 46 and the upper conductor plate 47.

On one surface perpendicular to the thickness direction Z of the intermediate layer 27, a wiring 54 is further formed which extends from the first source electrode 36 of the switching transistor 31 toward the upper conductor plate 47. This wiring 54 extends to a position in which an end of the wiring 54 on the upper conductor plate 47 side is overlapped with an end of the lower conductor plate 46 as viewed from one side perpendicular to the thickness direction Z. The intermediate layer 27 is provided with a through wiring 55 through the intermediate layer 27 perpendicular to the thickness direction Z, and this through wiring 55 electrically connects the end of the wiring 54 to the lower conductor plate 46.

The light emitting element 24 is formed on one surface perpendicular to the thickness direction Z of the interlayer insulating layer 23 formed to cover one surface perpendicular to the thickness direction Z of the TFT substrate 22. The light emitting element 24 is achieved by including a liquid crystal element or an organic EL, element, and in the present embodiment, configured to include an organic EL element. The light emitting element 24 according to the present invention is configured to include a first electrode 56, a second electrode 57, and an organic layer 58. The light emitting element 24 may be a so-called bottom emission organic EL element or a so-called top emission organic EL element, and is achieved by a bottom emission organic EL element in the present embodiment. The first electrode 56 corresponds to an anode , which is formed on the surface the thickness direction Z of the interlayer insulating layer 23. The organic layer 58 is formed on one surface perpendicular to the thickness direction Z of the first electrode 56. The organic layer may be achieved by a single emitting layer or composed of a plurality of layers including an emitting layer in stacked manner. The organic layer 58 according to the present embodiment is achieved by a hole injection layer formed on one surface perpendicular to the thickness direction Z of the first electrode 56 and a light emitting layer formed on one surface perpendicular to the thickness direction Z of the hole injection layer. The second electrode 57 corresponds to a cathode, which is formed on one surface perpendicular to the thickness direction Z of the organic layer 58.

The display device 21 has a protective film 59 further formed for covering the light emitting element 24 from one side perpendicular to the thickness direction Z.

The light emitting element 24 is located so as to be kept as much as possible from overlapping with the driving transistor 32 and the capacitor 33, as viewed from one side perpendicular to the thickness direction Z. The light emitting element 24 according to the present embodiment is located to partially overlap with an end of a wiring 61 extending in the first direction X from the second source electrode 43 of the driving transistor 32, as viewed from one side perpendicular to the thickness direction Z. The wiring 61 extending from the second source electrode 43 and the first electrode 56 of the light emitting element 24 are electrically connected by a through wiring 62 formed through the interlayer insulating layer 23. As described above, the light emitting element 24 and the element formed on the TFT substrate 22 are arranged so as to be kept as much as possible from overlapping with each other perpendicular to the thickness direction Z. Thus, incident light from the light emitting element 21 into the TFT substrate 22 can be prevented from attenuating in the TFT substrate 22.

The operation of the display device 21 will be described below with reference to FIG. 3. To the TFT substrate 22, scan signals (referred to as a symbol "Vscan" in FIG. 3) and data signals (referred to as a symbol "Vsig" in FIG. 3) are input from a signal generating unit provided in the display device 21. The first source electrode 36 of the switching transistor 31 and the second gate electrode 41 of the driving transistor 32 are electrically connected. In addition, the capacitor 33 is inserted between the second gate electrode 41 and second drain electrode 42 of the driving transistor 32. Furthermore, the second source electrode 43 of the driving transistor 32 is electrically connected to the first electrode 56 of the light emitting element 24. The scan signals from the signal generating unit are input to the first fate electrode 34 of the switching transistor 31, and the data signals from the signal generating unit are input to the first drain electrode 35 of the switching transistor 31. In addition, a driving voltage (referred to as a symbol "Vcc" in FIG. 3) from a driving power supply is applied to the second drain electrode 42 of the driving transistor 32.

When a high voltage is applied as a scan signal to the first gate electrode 34 of the switching transistor 31, the first drain electrode 35 and the first source electrode 36 are brought into a conduction state (which may be referred to as an ON state hereinafter). In the case of the switching transistor 31 in an ON state, when a high voltage is applied as a data signal to the first drain electrode 35 of the switching transistor 31, the data signal of the high voltage is provided to the second gate electrode 41 of the driving transistor 32, thereby bringing the second drain electrode 42 and the second source electrode 43 into a conduction state (ON state). With the driving transistor 32 in an ON state, the driving voltage (Vcc) is applied to the first electrode 56 (anode) of the light emitting element 24, thereby permitting the light emitting element 24 to emit light. More specifically, when both the scan signal and the data signal are input, the driving transistor 32 is brought into an ON state, thereby permitting the light emitting element 24 to emit light.

When no scan signal is input, that is, when a low voltage is applied to the first gate electrode 34 of the switching transistor 31, the first drain electrode 35 and first source electrode 36 of the switching transistor 31 are brought into a non-conduction state (which may be referred to as an OFF state hereinafter). In the case of the switching transistor 31 in an OFF state, even when a high voltage is applied as a data signal to the first train electrode 35 of the switching transistor 31, the data signal of the high voltage is not provided to the second gate electrode 41 of the driving transistor 32. Thus, the second drain electrode 42 and the second source 43 are brought into a non-conduction state (OFF state). In addition, even when a high voltage is input as a scan signal to bring the switching transistor 31 into an ON state, a low voltage is applied to the second gate electrode 41 of the driving transistor 41 in the same way as to the first drain electrode 35 of the switching transistor 31, unless a data signal is input, thereby bringing the driving transistor 41 into an OFF state. Therefore, when at least either one of the scan signal and the data signal fails to be input, the driving transistor 41 is brought into an OFF state, and the light emitting element 24 emits no light. As described above, only when both the scan signal and the data signal are input, the light emitting element 24 emits light. Therefore, the selective input of the scan signal and the data signal allows the light emitting element to selectively emit light.

As described above, the display device 21 according to the present embodiment includes a plurality of pixels. The respective pixels according to the present embodiment are arranged in a matrix of rows and columns perpendicular to the rows, on an imaginary plane perpendicular to the thickness direction Z. More specifically, the elements constituting each pixel as shown in FIGS. 1 and 2 are arranged in a matrix form. The first gate electrodes 34 of the switching transistors 31 for each element arranged in each row are electrically connected to each other for each row by a wiring for scan signals. In addition, the first drain electrodes 35 of the switching transistors 31 arranged in each column are electrically connected to each other for each column by a wiring for data signals. Therefore, a common scan signal is input to the first gate electrodes 34 of the switching transistors 31 arranged in the same row. In addition, a common data signal is input to the first drain electrodes 35 of the switching transistors 31 arranged in the same column. In this active matrix type display device 21, a plurality of light emitting elements 24 arranged in a specific row is selected by inputting a scan signal, and a specific column is selected by further inputting a data signal, thereby selectively allowing the light emitting element 24 arranged in the specific column to emit light among the selected specific column.

FIGS. 4 to 11 are cross-sectional views schematically illustrating manufacturing steps for the display device 21. A method for manufacturing the display device 21 according to the present embodiment will be described with reference to the drawings. First, as shown in FIG. 4, a substrate main body 25 is prepared. This substrate min body 25 is not limited to a rigid substrate, and may be a flexible substrate. For the substrate main body 25, substrates which are not deformed in the step of forming electrode and forming organic layers are preferably used, and for example, a glass substrate, a plastic substrate, a polymer film, a silicon substrate, and a stack thereof, etc, are used. In addition, since the display device 21 according to the present embodiment includes the bottom emission type light emitting element 24, a transparent substrate is used for the substrate main body 25 so that light from the light emitting element 24 can be extracted from the substrate main body 25 side. It is to be noted that in the case of a display device 21 including a top emission type light emitting element 24, a non-light transmitting substrate may be used for the substrate main body 25, and for example, a stainless substrate or a single crystal semiconductor substrate, etc. may be used.

Next, an application liquid containing a material for constituting a base layer 26 is formed by an application method on one surface perpendicular to the thickness direction Z of the substrate main body. The base layer 26 is formed of a member whose adhesiveness to electrodes such as first and second gate electrodes 34, 41 is higher than the adhesive feature of a substrate main body 25 to electrodes when forming the electrodes on one surface of the substrate main body 25 by an application method. When the substrate main body 25 is composed of, for example, a glass substrate whereas the electrodes are formed of, for example, metals such as silver (Ag) and copper (Cu) described below, a photosensitive material, for example, is used to form the base layer 26. As the photosensitive material, materials for use as a negative photoresist, a positive photoresist, or the like, and photosensitive resins such as a photosensitive polyimide can be used. As the negative or positive photoresist, a photoresist is used which uses, as a main resin in the composition, a novolac resin, a polyvinylphenol resin, a polyisopropenylphenol resin, an acrylic resin, an alkyd resin, a polyester resin, a modified epoxy resin, a modified phenol resin, a polyether resin, an amino resin, a melamine-formaldehyde resin, or the like, and preferably, a photoresist is used which uses a novolac resin, a polyvinylphenol resin, or an acrylic resin. In addition, as the negative or positive photoresist, an alkali soluble photoresist is preferable in the case of using alkaline solutions such as an alkaline developer and an alkali stripper in a developing step and post-processing steps such as rework. In the present embodiment, first, a spin coating apparatus is used to apply a negative photosensitive material on one surface perpendicular to the thickness direction Z of the substrate main body 25. Next, a prebake process is carried out. Specifically, a heat treatment is carried out for 20 minutes to 30 minutes in an atmosphere at 80°C to 90°C, for example. Next, the entire surface of the applied photosensitive material is exposed. Next, a developing process is carried out by the use of a developer. As the developer, for example, alkaline solutions such as tetramethylammonium hydroxide (TMAH) and potassium hydroxide (KOH) can be cited. The developing process carried out as described allows one surface perpendicular to the thickness direction Z of the base layer 26 to be formed in an uneven shape. Next, a postbake process is carried out. Specifically, a heat treatment is carried out for 60 minutes to 70 minutes in an atmosphere at 150°C to 200°C, for example. Depending on the condition of the postbake process, the surface perpendicular to the thickness direction Z of the base layer 26, which has been formed into an uneven shape, may be planarized. However, the heat treatment carried out under the conditions according to the present embodiment allows the postbake processing to be carried out while the surface perpendicular to the thickness direction Z of the base layer 26 is kept in an uneven shape.

The light transmission rate of the base layer 26 is typically set at 80% or more, preferably set at 90% or more. The thickness in the thickness direction Z of the base layer 26 is set in consideration of the light transmission rate, etc.

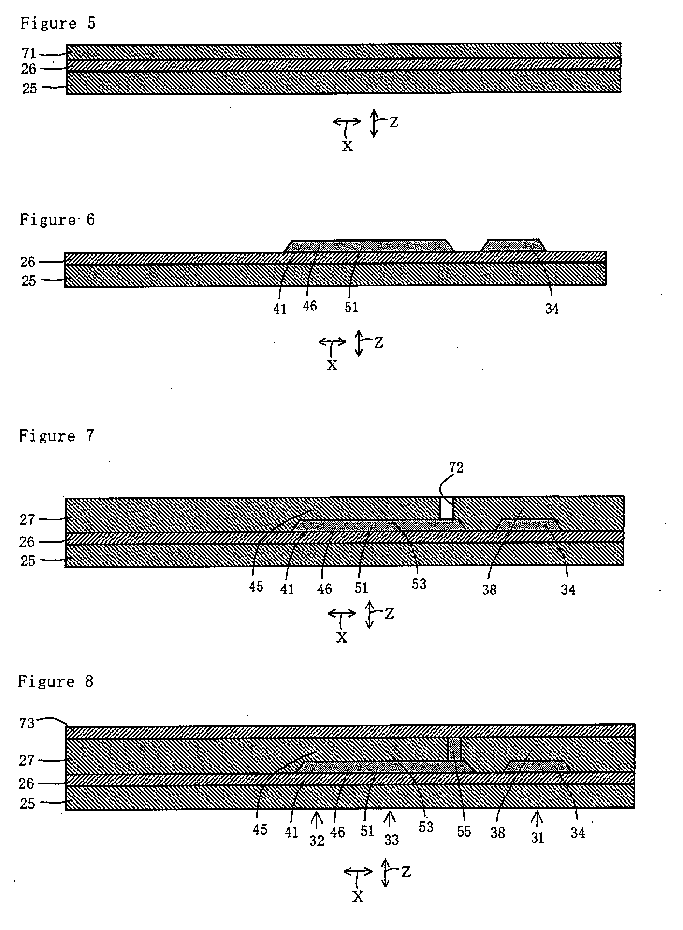

Next, as shown in FIG. 5, a conductive layer 71 to serve as electrode and wirings, etc. is formed by an application method. Specifically, a suspension with metal fine particles dispersed in a dispersion medium is applied on one surface perpendicular to the thickness direction Z of the base layer 26 by use of a spin coating apparatus, and calcinations is further carried out at 180°C to 300°C in a clean oven. As the metal, silver (Ag) and copper (Cu), etc. can be cited, and it is preferable use low resistivity silver. The fine particles have a particle size selected to range from 2 nm to 500 nm, and preferably, the individual particles have a diameter of 2 nm to 7 nm. In addition, as the dispersion medium, toluene and xylene, etc. can be cited, and toluene is preferably used.

Next, as shown in FIG. 6, the semiconductor layer 71 is subjected to predetermined patterning by photolithography to form a first gate electrode 34, a lower conductor plate 46, and a predetermined wiring, thereby obtaining the first gate electrode 34, a second gate electrode 41, one conductor plate 51, and the predetermined wiring. Specifically, a photosensitive material is first applied from one side perpendicular to the thickness direction Z, a prebake process is carried out, a predetermined region of the photosensitive material applied through a mask is exposed to light to carry out a developing process, and a postbake processing is carried out, thereby forming a resist patterned in a predetermined shape. Next, the semiconductor layer 71 is subjected to patterning into a predetermined shape by use of an etchant such as a nitric acid and an acetic acid, followed by removal of the resist, thereby forming the first gate electrode 34, etc.

Next, as shown in FIG. 7, an intermediate layer 27 is formed by an application method. The intermediate layer 27 is formed by the use of, for example, a photosensitive material in the same way as the base layer 26 described above. In the present embodiment, a spin coating apparatus is first used to apply a negative photosensitive material on the entire surface from one side perpendicular to the thickness direction Z.

Next, a prebake processing is carried out. Specifically, a heat treatment is carried out for 20 minutes to 30 minutes in an atmosphere at 80°C to 90°C, for example, for example. Next, a mask with a predetermined pattern formed is disposed on one side in the thick direction Z of the photosensitive material. Next, the photosensitive material applied through the disposed mask is irradiated with light to irradiate a predetermined region with light, except for a region in which a through wiring 55, etc. are to be formed. Next, a developer is used to carry out a developing processing. As the developer, for example, alkaline solutions such as tetramethylammonium hydroxide (TMAH) and potassium hydroxide (KOH) can be cited. This developing process forms a through hole 72 in a predetermined position of the intermediate layer 27. Next, a postbake process is carried out. Specifically, a heat treatment is carried out for 60 minutes to 70 minutes in an atmosphere at 150°C to 200°C.

The light transmission rate of the intermediate layer 27 is typically set at 80% or more, preferably set at 90% or more. The thickness in the thickness direction Z of the intermediate layer 27 is set in consideration of the light transmission rate, the dielectric constant, etc, and for example, selected to be 1 µm to 3 µm.

Next, as shown in FIG. 8, a conductive layer 73 to serve as electrodes, wirings, etc. and a through wiring 55 are formed by an application method. These layer and wiring can be formed in the same way as the semiconductor layer 71 formed on one surface perpendicular to the thickness direction Z of the base layer 26. Since the through hole 72 formed in the intermediate layer 27 is filled by spin coat with a suspension with silver and copper, etc. dispersed therein, the through wiring 55 is also formed in the same step as the semiconductor layer 73.

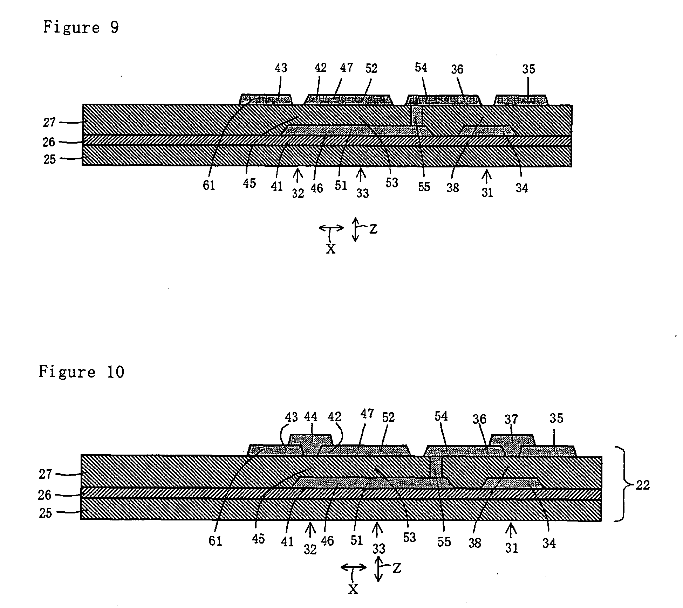

Next, as shown in FIG. 9, the semiconductor layer 73 formed on one surface perpendicular to the thickness direction Z of the intermediate layer 27 is subjected to patterning into a predetermined shape to form a first drain electrode 35, a first source electrode 36, a second drain electrode 42, a second source electrode 43, the other conductor plate 52, and predetermined wirings, etc. The patterning of the conductive layer 73 can be carried out in the same way as the patterning of the semiconductor layer 71 formed on one surface perpendicular to the thickness direction Z of the base layer 26.

Next, as shown in FIG. 10, first and second semiconductor layers 37, 44 are formed. The first and second semiconductor layers 37, 44 can be formed by an application method such as an inkjet method and a printing method, and an evaporation method, etc. Materials for constituting the first and second semiconductor layers 37, 44 include phthalocyanines, pentacene, polythiophene derivatives, and polyaniline. In the application method, the first and second semiconductor layers 37, 44 can be formed by applying an application liquid with a material for constituting the first and second semiconductor layers 37, 44 dissolved in a liquid, in a predetermined position. Alternatively, in the evaporation method, for example, a material for constituting the first and second semiconductor layers 37, 44, such as pentacene is supplied to a crucible, the substrate is placed with the surface opposed to the crucible, on which the first and second semiconductor layers 37, 44 are to be formed, and further, a mask patterned into a predetermined shape is placed between the crucible and the substrate. Next, the material contained in the crucible can be overheated to be deposited on the substrate, thereby forming the first and second semiconductor layers 37, 44. In this way, a TFT substrate 22 can be obtained.

Next, as shown in FIG. 11, an interlayer insulating layer 23 and a through wiring 62 are formed. The interlayer insulating layer 23 and the through wiring 62 can be formed respectively in the same way as the intermediate layer 27 and the through wiring 55 formed in the intermediate layer 27. The light transmission rate of the interlayer insulating layer 23 is set at 80% or more, preferably set at 90% or more. In addition, the thickness in the thickness direction Z of the interlayer insulating layer 23 is set in consideration of the light transmission rate, the dielectric constant, etc.

Next, a first electrode 56 is formed in a predetermined position, for example, by sputtering and evaporation, etc. For example, a transparent conductive film such as an ITO (indium tin oxide) or IZO (indium zinc oxide) is deposited by use of CVD, sputtering and evaporation, etc., and patterning of the deposited conductive film is carried out by applying photolithography and etching to the conductive film, thereby forming the first electrode 56 in a predetermined shape.

Next, an organic layer 58 is formed by an application method or an evaporation method. For example, in the case of forming the hole injection layer described above, an application liquid with a material for constituting the hole injection layer dissolved in a solvent is first applied by, for example, inkjet and a printing, etc., and further, the solvent is evaporated by a heat treatment, thereby allowing the hole injection layer to be formed. In addition, in the case of forming the light emitting layer described above, an application liquid with a material for constituting the light emitting layer dissolved in a solvent is first applied on the hole injection layer by, for example, inkjet and a printing, etc., and further, the solvent is evaporated by a heat treatment, thereby allowing the light emitting layer to be formed.

Next, a second electrode 57 is formed by, for example, sputtering, evaporation, and laminating through thermo-compression bonding of a metal thin film. When the second electrode 57 is to be formed, the organic layer 58 may be damaged. Thus, in the case of forming the second electrode 57 by sputtering, it is preferable to use sputtering which causes less damage. As the second electrode 57, for example among metals, alkali metals, alkaline-earth metals, transition metals, III-B group metals can be used. For example, a metal such as lithium, sodium, potassium, rubidium, cesium, beryllium, magnesium, calcium, strontium, barium, aluminum, scandium, vanadium, zinc, yttrium, indium, cerium, samarium, europium, terbium, ytterbium, or an alloy of two or more of the metals mentioned above, or an alloy of one or more of the metals and one or more of gold, silver, platinum, copper, manganese, titanium, cobalt, nickel, tungsten, and tin, or a graphite or graphite intercalation compound, etc. is used. Examples of the alloy include a magnesium-silver alloy, a magnesium-indium alloy, a magnesium-aluminum alloy, an indium-silver alloy, a lithium-aluminum alloy, a lithium-magnesium alloy, a lithium-indium alloy, and a calcium-aluminum alloy.

The protective film 59 can be formed by, for example, evaporation and CVD. For example, a silicon nitride film can be deposited by CVD from one surface perpendicular to the thickness direction Z of the light emitting element 14 to form the protective film 59 covering the light emitting element 24. While the protective film 59 is formed in the present embodiment, a plate-like sealing substrate may be attached to the TFT substrate 22 for sealing of the light emitting element 24.

In the display device 21 according to the present embodiment as described above, the base layer 26 is formed between the electrodes such as the first and second electrodes 34, 41 and the substrate main body 25. The base layer 26 is formed of a member whose adhesiveness to electrodes is higher than the adhesiveness of the substrate main body 26 to electrodes in the case of forming the electrodes on one surface of the substrate main body 26 by an application method. The base layer 26 thus provided improves the adhesiveness of the electrodes, as compared with cases of forming the electrodes directly on the substrate main body 26 without providing the base layer 26, thereby allowing the TFT substrate 22 provided with the highly reliable switching and driving transistors 31, 32 with their electrodes having a high adhesiveness to be obtained.

In addition, since the highly adhesive electrode can be formed, the electrodes can be prevented from peeling in reprocessing, and the yield can be thus improved.

In addition, since the electrodes can be formed by an application method, the TFT substrate 22 can be manufactured at low cost, as compared with cases of forming the electrodes by use of a vacuum apparatus.

In addition, in the present embodiment, the intermediate layer 27 which functions as the first and second insulating films 38, 45 and the dielectric section 53, and the conductive member provided on one surface perpendicular to the thickness direction Z of the intermediate layer 27 are formed by the application method, thus allowing the TFT substrate 22 to be manufactured at low cost, as compared with cases of the formation by use of a vacuum apparatus.

Furthermore, in the case of forming the first and second semiconductor layers 37, 44 by an application method, all of the elements to be provided over the base layer 26 can be formed by an application method, thus allowing the TFT substrate 22 to be manufactured at low cost, as compared with cases of the formation by use of a vacuum apparatus.

In addition, the base layer 26, the intermediate layer 27, and the interlayer insulating layer 23 according to the present embodiment are formed with the use of a photosensitive material. Thus, photolithography can be used, thereby allowing the display device 21 to be manufactured in accordance with a simple step.

In addition, the base layer 26, the intermediate layer 27, and the interlayer insulating layer 23 according to the present embodiment have light transmission rates set at 80% or more. Thus, light from the bottom emission type light emitting element 24 can be prevented from attenuating to effectively extract the light from the substrate main body 25 side.

In addition, the first and second gate electrodes 34, 31, the first and second drain electrodes 35, 42, the first and second source electrodes 36, 43, one and the other conductor plates 51, 52, and the wirings according to the present invention are formed by the application method from a suspension in which metal fine particles are dispersed with a particle size in the range of 2 nm or more and 500 nm or less, thus allowing low resistance members to be formed.

In addition, one surface perpendicular to the thickness direction Z of the base layer 26 according to the present embodiment is preferably formed in an uneven shape, thereby increasing the area of contact of the conductive members formed on one surface of the base layer 26, such as the first and second gate electrodes 34, 31, one conductor plate 51, and the wiring, with the base layer 26, and allowing the adhesiveness to be improved. In addition, one surface perpendicular to the thickness direction Z of the intermediate layer 27 according to the present embodiment is formed in an uneven shape, thereby increasing the area of contact of the conductive members formed on one surface of the base layer 27, such as the first and second drain electrodes 35, 42, the first and second source electrodes 36, 43, the other conductor plate 52, and the wiring, with the intermediate layer 27, and allowing the adhesiveness to be improved.

In addition, the base layer 26 and the intermediate layer 27 have one surface formed into an uneven shape by carrying out a developing process after the application of a photosensitive material, thus allowing surfaces perpendicular to the thickness direction Z of the base layer 26 and intermediated layer 27 to be formed into an uneven shape in accordance with a simple step.

While the switching and driving transistors 31, 32 according to the present embodiment are achieved by bottom-gate type FETs, the present invention is not limited to this type, the transistors may be achieved by top-gate type FETs or the like. In addition, while one switching transistor 31 and one driving transistor 32 are provided for each light emitting element 24, multiple switching transistors 31 connected in parallel and multiple driving transistors 32 connected in parallel may be provided per one light emitting element 24.

In addition, while the first and second semiconductor layers 37, 44 according to the present embodiment are formed by organic semiconductors, for example, inorganic semiconductors such as amorphous silicon and polysilicon may be deposited by CVD or the like to form the first and second semiconductor layers 37, 44.

In addition, while the light emitting element 24 is achieved by a bottom emission type organic EL element in the present embodiment, the light emitting element 24 may be achieved by a top emission type organic EL element, or may be achieved by a liquid crystal element. In the case of achieving the light emitting element 24 by a liquid crystal element, there is no need to flow high currents because the liquid crystal element is a type of elements driven by a voltage, and for example, the light emitting element 24 is permitted to emit light by only providing one FET for each light emitting element 24.

### Example

As an example, a test substrate with a substrate main body, a base layer, and a conductive layer stacked in this order was manufactured.

First, a glass substrate of 200 mm × 200 mm was prepared as a substrate main body, a negative photosensitive material containing an acrylic resin as a main component of the composition was then applied on the entire of one surface of the substrate main body, a prebake process was carried out for heating at 95°C for 10 minutes, the applied photosensitive material was further exposed to light, a developing process was carried out by the use of KOH, and a postbake process was further carried out for heating at 170°C for 30 minutes, thereby forming a base layer.

Next, a suspension with Ag of 3 nm to 5nm in particle size dispersed in toluene was applied on one surface perpendicular to the thickness direction Z of the base layer, and a heat treatment was carried out for heating at 170°C for 30 minutes, thereby forming a conductive layer.

In the example, the substrate main body had a thickness of 0.7 mm, the base layer had a thickness of 1 µm, and the conductive layer had a thickness of 0.5 µm.

In addition, as a comparative example, a substrate with a conductive layer formed on one surface perpendicular to the thickness direction of a substrate main body was manufactured without forming the base layer. For the substrate main body, the same substrate main body as in the example was used, and further, the conductive layer was manufactured under the same conditions as in the case of the conductive layer of the example.

In the comparative example, the substrate main body had a thickness of 0.7 mm, and the conductive layer had a thickness of 0.5 µm.

For the test substrates according to the example and the comparative example, a peeling test was carried out in which cuttings referred to as cross cut were formed at four corners, an adhesive tape was attached to a region of the surface of the semiconductor layer with the cross cut formed, and further, the adhesive tape was separated. As the cross cut, cuttings were formed from the conductive layer side toward the substrate main body side by the use of a cutter to form cutting in a grid. Specifically, five cuttings extending parallel to each other in rows and five cuttings extending parallel to each other in columns and orthogonal to the cuttings extending in rows were formed. The distance between the cuttings for each row and the distance between the cuttings for each column were respectively 2 mm to 3 mm. These cuttings are estimated to reach one surface perpendicular to the thickness direction of the substrate main body. For the test substrate provided with the base layer according to the example, the semiconductor layer was not peeled from the base layer when the adhesive tape was separated. However, for the test substrate provided with no base layer according to the comparative substrate, the semiconductor layer was peeled from the substrate main body when the adhesive tape was separated. It was confirmed that even when the application method was used in this way, the conductive layer which was not likely to be peeled was formed by providing the base layer. For the TFT substrate and the display device including the TFT substrate according to the present invention, electrodes and wirings are formed from a conductive layer which is not likely to be peeled as described above, and thus, highly adhesive electrodes and wirings are formed.

### INDUSTRIAL APPLICABILITY

According to the present invention, a control substrate can be obtained which includes highly reliable switching elements with their electrodes having a high adhesiveness.

In addition, since highly adhesive electrodes can be formed, the electrodes can be prevented from peeling in reprocessing, and the yield can be thus improved, and even when reprocessing is carried out, a control substrate provided with highly reliable switching elements can be obtained.

In addition, since the electrodes can be formed by an application method, the control substrate can be manufactured at low cost, as compared with cases of forming the electrodes by use of a vacuum apparatus.

## Claims

1. A control substrate comprising:
a substrate main body;
a base layer provided on one surface perpendicular to a thickness direction of the substrate main body; and
a switching element provided on the base layer's surface located on the opposite side to the substrate main body ,so as to perform switching between an electric connection and an electric disconnection,
wherein the switching element comprises an electrode formed on the surface of the base layer by an application method,the surface being opposite to the substrate main body , and
the base layer is formed of a member whose adhesiveness to the electrode is higher than the adhesiveness of the substrate main body to an electrode when forming the electrode on a base layer side surface of the substrate main body by an application method.

2. The control substrate according to claim 1, wherein the switching element further comprises:
an intermediate layer formed over at least the electrode from the side opposite to the substrate main body; and
an upper electrode formed by an application method on one surface perpendicular to a thickness direction of the intermediate layer.

3. The control substrate according to claim 2, wherein the base layer and the intermediate layer are formed by the use of a photosensitive material.

4. The control substrate according to claim 2 or 3, wherein each of the base layer and the intermediate layer has a light transmission rate of 80% or more.

5. The control substrate according to any one of claims 2 to 4, wherein the electrode and the upper electrode are formed by an application method from a suspension in which metal fine particles are dispersed, the metal fine particles having a particle size in the range of 2 nm to 500 nm.

6. The control substrate according to any one of claims 1 to 5, wherein the base layer's surface in contact with the electrode has an uneven shape.

7. A display device comprising:
the control substrate according to any one of claims 1 to 6;
an interlayer insulating layer formed on a surface of the control substrate,the surface being opposite to the substrate main body side; and
a light emitting element provided on one surface perpendicular to a thickness direction of the interlayer insulating layer.

8. The display device according to claim 7, wherein the interlayer insulating layer is formed by the use of a photosensitive material.

9. A method for manufacturing a control substrate comprising a substrate main body, a base layer provided on one surface perpendicular to a thickness direction of the substrate main body, a switching element provided on the base layer for switching between an electric connection and an electric disconnection, the method comprising the steps of:
forming the base layer by an application method; and
forming an electrode for the switching element by an application method on a surface of the base layer, the surface being opposite to the substrate main body,
wherein the base layer is formed of a member whose adhesiveness to the electrode is higher than the adhesiveness of the substrate main body to an electrode when forming the electrode on a base layer side surface of the substrate main body by an application method.

10. The method for manufacturing a control substrate according to claim 9, wherein the base layer is formed of a photosensitive material, and
in the step of forming the base layer by the application method, the base layer's surface to be in contact with the electrode is formed into an uneven shape by applying a photosensitive material on one surface perpendicular to the thickness direction of the substrate main body, and then carrying out a developing process.

11. The method for manufacturing a control substrate according to claim 9 or 10, the method further comprising:
a step of forming by an application method an intermediate layer covering at least the electrode from the side opposite to the substrate main body after the step of forming the electrode; and
a step of forming an upper electrode by an application method on one surface perpendicular to a thickness direction of the intermediate layer.

12. A method for manufacturing a display device, the method comprising the steps of:
forming a control substrate by the method for manufacturing a control method according to any one of claims 9 to 11;
forming an interlayer insulating layer on a surface of the control substrate ,the surface being opposite to the substrate main body; and
forming a light emitting element on one surface in a thickness direction of the interlayer insulating layer.
